# EUROPEAN PATENT APPLICATION

(11) **EP 4 650 036 A1**
(43) Date of publication of application: **19.11.2025**
(21) Application number: 23923013.9
(22) Date of filing: 19.05.2023
(51) Int. Cl.: B01D 53/75, B01D 53/78, B01D 53/00, B01D 53/32, H01L 21/67

(54) **MODULAR WASTE GAS REDUCTION APPARATUS HAVING PLURALITY OF REACTION CHAMBERS**

(30) Priority: 17.02.2023 KR 20230021350; 24.03.2023 KR 20230038766
(71) Applicant: Triple Cores Technology Co., Ltd., Yongin-si, Gyeonggi-do 17086 (KR)
(72) Inventor: KIM, Ik Nyun, Seoul 06676 (KR); YOU, Jae Bong, Anseong-si Gyeonggi-do 17600 (KR); BIAN, Kangzhe, Shanghai 200123 (CN)
(74) Representative: Manitz Finsterwald Patent- und Rechtsanwaltspartnerschaft mbB
(86) International application number: PCT/KR2023/006855
(87) International publication number: WO 2024/172212

(57) **Abstract**

A waste gas reduction device with multiple reaction chambers includes a reaction module 100 including a reaction chamber 120 therein and excluding a water treatment exhaust pipe, a water treatment module 200 including a water treatment exhaust pipe 220 therein, and a connection pipe 140 connecting the reaction chamber in the reaction module to the water treatment exhaust pipe of the water treatment module, in which there are a plurality of reaction modules arranged, and the reaction chamber of each reaction module is connected to the water treatment exhaust pipe through the connection pipe.

## Description

### Technical Field

The disclosure relates to a modular waste gas reduction device with multiple reaction chambers, and more specifically, to a waste gas reduction device with multiple reaction chambers, which is a new concept of scrubber device that newly improves a limited way of configuring a related point of use (POU) scrubber that includes an inlet, a reaction chamber, a wet tank, and a wet tower, by integrating common parts of the above components.

### Background Art

Semiconductor devices are manufactured through various manufacturing processes such as oxidation, etching, deposition, and photolithography, and in such manufacturing processes, toxic chemicals or chemical gases may be used. For example, toxic gases such as carbon tetrafluoride, sulfur hexafluoride, nitrogen trifluoride, ammonia, nitrogen oxide, arsine, posipine, diboron, boron trichloride etc. may be used in the semiconductor device manufacturing process. Therefore, if the waste gas generated in the semiconductor manufacturing process is discharged into the atmosphere as is, the toxic gas described above may have a fatal effect on human health. The climate change or global warming due to discharging of various greenhouse gases is also one of the most important current international environmental issues. For this reason, various types of gas reduction equipment (scrubber) are used in the semiconductor manufacturing process. The gas reduction equipment purifies waste gas generated in the semiconductor manufacturing process by decomposing or diluting the same before the gas is released into the atmosphere.

Various types of harmful waste gases are discharged from the semiconductor manufacturing process in each process, and specifically, once released into the atmosphere, the gases used for cleaning and etching the semiconductors remain in the atmosphere for a long time, blocking infrared rays and resulting in increased atmospheric temperature of the surface. Therefore, international regulations are tightening to completely destroy the fluorinated gases used in the industry before releasing them into the atmosphere. Studies to remove fluorinated gases have been conducted in various fields, and one of them relates to an effort to ionize these molecules using plasma and make them into other harmless molecules before releasing the same.

Semiconductor exhaust gases include fluorine compounds called "perfluoro compounds (PFCs)," as well as oxygen (O₂), hydrogen (H₂), ammonia (NH₃), methane (CH₄), tungsten (WO₃), titanium dioxide (TiO₂), materials such as alumina (Al₂O₃) alone or in combination. Specifically, the proportion occupied by PFCs is small compared to other gases such as nitrogen (N₂) or argon (Ar), but PFCs have a very high global warming coefficient (GWP) that is thousands to tens of thousands of times greater than that of carbon dioxide (CO₂), and the lifetime in atmosphere is also longer by thousands of years to tens of thousands of years compared to CO₂. It is known that perfluoro-carbons represented by CF₄ and C₂F₆ cannot be easily decomposed because of stable C-F bond. Therefore, various technologies have been developed to remove various harmful materials including the used PFCs from the semiconductor exhaust gases.

The related systems have limitations in terms of maintenance cost and thermal efficiency for reaction, and the related POU special gas reduction equipment for semiconductor requires regular maintenance to maintain removal efficiency above a certain level, which requires frequent disassembly and assembly of the system, but this work has high level of difficulty and there is a risk of safety accidents. However, the related special gas reduction equipment has problems that it needs a large number of workers for efficient equipment management, and it is difficult to secured sufficient space, and cost for back up between the equipment requires large cost due to distances therebetween.

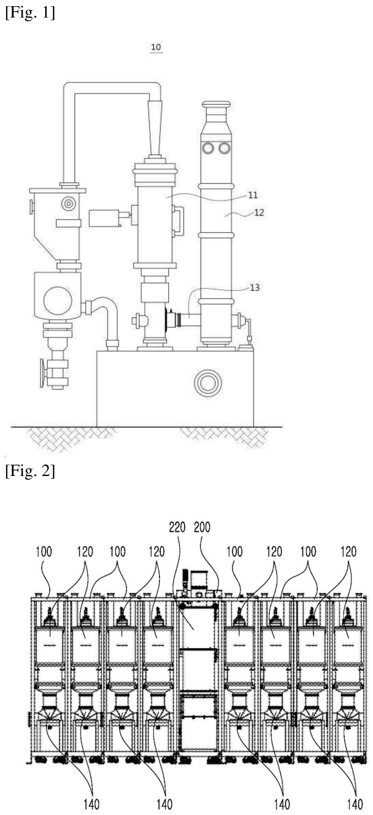

FIG. 1 is a schematic view illustrating a structure of a general related special gas reduction equipment used in a semiconductor manufacturing process, for example. Referring to FIG. 1, the special gas reduction equipment 10 includes a reaction chamber 11 for burning the waste gas generated in a semiconductor manufacturing process or the like, and a water treatment exhaust pipe 12 for water treatment of the waste gas burned in the reaction chamber 11. At this time, the reaction chamber 11 burns the waste gas to decompose harmful components contained in the waste gas into harmless or low-toxic gases. For example, components such as CF₄ and NF₃ contained in the waste gas are burned in the reaction chamber 11 and decomposed into CO₂+HF.

Meanwhile, since HF and F- as described above are harmful against the human body when exposed to the external air, they are collected while passing through the reaction chamber 11 and the water treatment exhaust pipe 12. The waste gas passed through the reaction chamber 11 is in a high temperature state due to burning in the reaction chamber 11, and accordingly, in order to improve the powder collection efficiency, the gas is cooled down while flowing from the reaction chamber 11 to the water treatment exhaust pipe 12. The waste gas decomposed in the reaction chamber 11, which contains HF and F- is dissolved while passing through a cooling connection pipe 13 which connects the reaction chamber 11 and the water treatment exhaust pipe 12 and which also performs cooling.

However, the related special gas reduction equipment includes the reaction chamber 11, the water treatment exhaust pipe 12 and so on as separated equipment configurations, and as a result, there is a problem of requiring a very large amount of water for cooling. Further, since each reaction module should be provided with both the reaction chamber and the water treatment exhaust pipe, there is a problem of increasing installation space of the gas reduction equipment, and thus, decreasing space utilization.

### SUMMARY

An object of the disclosure is to provide a new concept of waste gas reduction device, which is a waste gas reduction device with multiple reaction chambers, which is capable of increasing the efficiency of installation space, saving unnecessary parts, and also saving water consumption.

According to an embodiment, a waste gas reduction device with multiple reaction chambers is provided, which is a waste gas reduction device applying a modular method. Specifically, the waste gas reduction device may include a reaction module 100 including a reaction chamber 120 therein and excluding a water tank and a water treatment exhaust pipe, a water treatment module 200 including a water tank and a water treatment exhaust pipe 220 therein, and a connection pipe 140 connecting the reaction chamber in the reaction module to the water treatment exhaust pipe of the water treatment module, in which there may be a plurality of reaction modules arranged, and the reaction chamber of each reaction module may be connected to the water treatment exhaust pipe through the connection pipe.

The connection pipe may be located below the reaction chamber and in communication with the reaction chamber, and shutoff valves 150 and 155 may be provided on both sides and an upper portion of the connection pipe, thereby achieving a structure that is capable of blocking communication between a reaction chamber of each reaction module and a reaction chamber of the neighboring reaction module.

In addition, shutoff valves 250 are provided on both sides of the connection pipe located below the water treatment exhaust pipe, thus achieving a structure that is capable of blocking communication between each water treatment exhaust pipe and the neighboring reaction chamber.

There may be a plurality of reaction modules disposed adjacent to both left and right sides of the water treatment module, and further, there may be a plurality of reaction modules arranged radially around the water treatment module at the center.

The related scrubber equipment is configured as one device including an inlet, a reaction chamber, a wet tank, and a wet tower, but the disclosure integrates a plurality of scrubber devices systemically, by including a separate reaction housing having an inlet pipe and a reaction part only, and providing a common water tank and a common water washing exhaust pipe for the water tanks and the washing exhaust pipes used for the reaction housing. As a result, a problem of consuming a large amount of water for washing is solved, energy is saved, equipment maintenance cost is reduced, and beneficial effects such as efficient use of equipment installation space are provided.

### BRIEF DESCRIPTION OF THE DRAWINGS

FIG. 1 illustrates an example of a related scrubber arrangement.
FIG. 2 is an internal view of a waste gas reduction device with multiple reaction chambers according to an embodiment.
FIG. 3 is a perspective view of the waste gas reduction device with multiple reaction chambers according to an embodiment, showing an internal view after removing a front door and part of a body case.
FIGS. 4A, 4B and 5 are views of a reaction module which is one component of the waste gas reduction device with multiple reaction chambers according to an embodiment.
FIGS. 6 and 7 are views of a water treatment module which is another component of the waste gas reduction device with multiple reaction chambers according to an embodiment.
FIGS. 8 and 9 illustrate a circular arrangement as an example of the arrangement structure of the waste gas reduction device with multiple reaction chambers according to an embodiment.
FIGS. 10 and 11 illustrate a circular arrangement as an example of the arrangement structure of the waste gas reduction device with multiple reaction chambers according to an embodiment, in which one of the reaction modules is omitted.
FIG. 12 is a view of a water treatment module for use in the waste gas reduction device shown in FIGS. 8 to 11.
FIGS. 13 and 14 illustrate other forms of the arrangement structure of the waste gas reduction device with multiple reaction chambers according to an embodiment.

### DETAILED DESCRIPTION

The objectives, specific advantages and novel features of the present disclosure will become more apparent from the following detailed description and the preferred embodiments, which are associated with the accompanying drawings. In addition, terms described herein are terms defined in consideration of functions in the present invention, which may vary according to the intention or convention of a user or an operator. Therefore, definitions of these terms should be made based on the contents throughout the present specification.

In addition, in describing the components of the disclosure, different reference numerals may be assigned to components having the same name depending on drawings, and the same reference numerals may be assigned even in different drawings. However, even in this case, it does not mean that the corresponding component has different functions depending on embodiments or has the same function in different embodiments, and the function of each component should be understood based on the description of each component.

In addition, unless specifically defined otherwise herein, technical terms used in the description should be interpreted as being commonly understood by those of ordinary skill in the art to which the disclosure belongs, and should not be interpreted as excessively comprehensive or excessively brief. Further, singular expressions used herein include plural expressions unless the context indicates separately.

In this application, terms such as "composed of" or "comprising" should not be construed as meaning that all of the various components or steps described in the description are necessarily included, and it should be construed that some of the components or some of the steps may not be included, or that other additional components or steps may be included.

The disclosure relates to a method which replaces and is more efficient than the related scrubber, saves water and energy, and allows efficient management and ease of maintenance. The waste gas reduction device (scrubber) with multiple reaction chambers according to an embodiment will be described below, in which a reaction part (reaction chamber) has a structure that can apply all of the related general thermal type, burn type, plasma type, scrubber utilizing catalyst, etc., and will not be described in detail below since these methods are common techniques in the art.

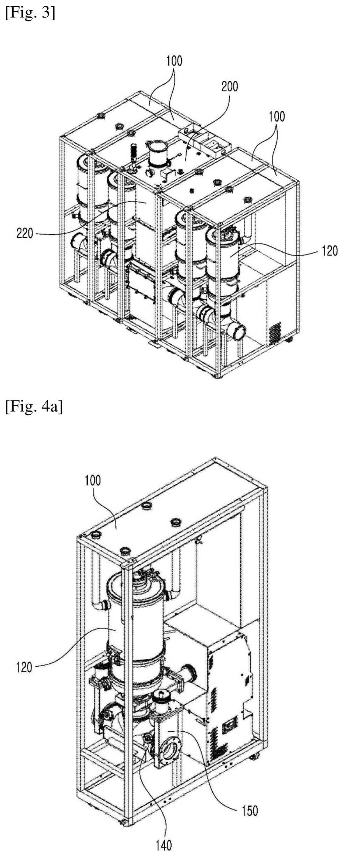

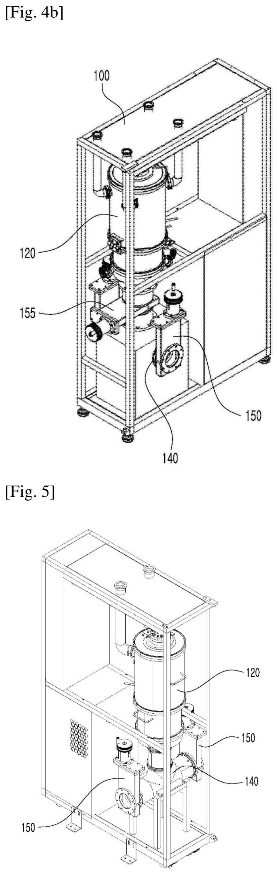

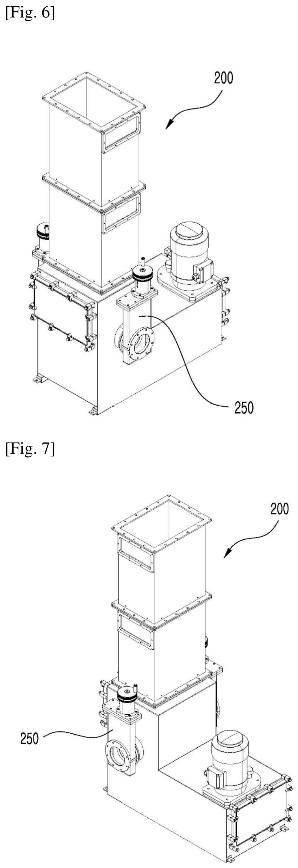

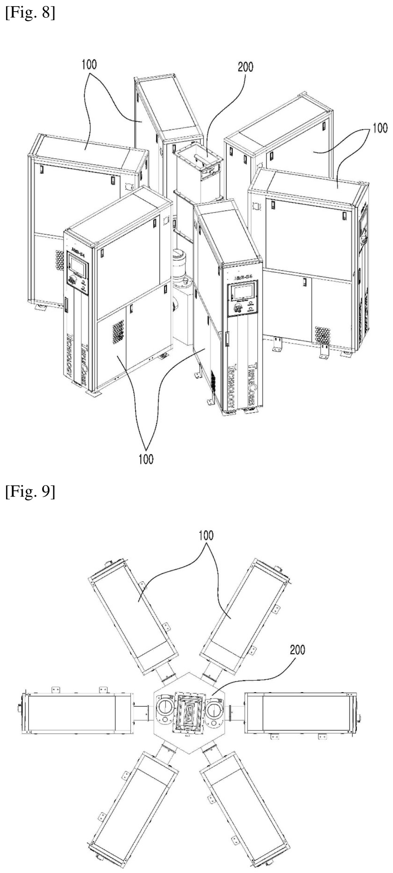

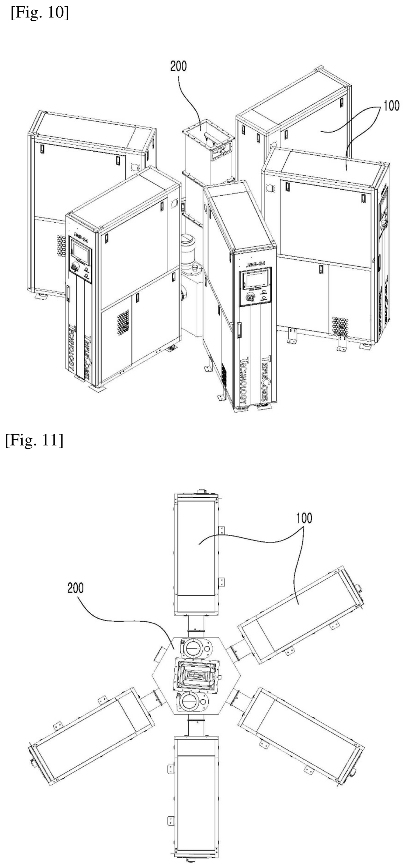

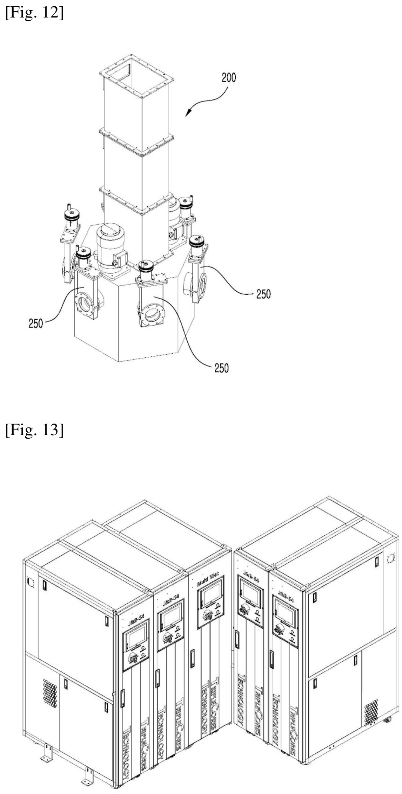

FIG. 2 is an internal view of the waste gas reduction device with multiple reaction chambers according to an embodiment, FIG. 3 is a perspective view of the waste gas reduction device with multiple reaction chambers according to an embodiment, showing an internal view after removing a front door and part of a body case, FIGS. 4A, 4B and 5 are views of a reaction module which is one component of the waste gas reduction device with multiple reaction chambers according to an embodiment, FIGS. 6 and 7 are views of a water treatment module which is another component of the waste gas reduction device with multiple reaction chambers according to an embodiment, FIGS. 8 and 9 illustrate a circular arrangement as an example of the arrangement structure of the waste gas reduction device with multiple reaction chambers according to an embodiment, FIGS. 10 and 11 illustrate a circular arrangement as an example of the arrangement structure of the waste gas reduction device with multiple reaction chambers according to an embodiment, in which one of the reaction modules is omitted, and FIG. 12 is a view of a water treatment module for use in the waste gas reduction device shown in FIGS. 8 to 11.

Referring to FIGS. 2 and 3, the scrubber device according to an embodiment is essentially characterized in that the water treatment cooling tower (cooling tower) is removed from the individual unit equipment including the reaction chamber (reaction chamber), and that, instead of the cooling towers, a common water treatment cooling tower is configured in a separate cabinet (housing). That is, the waste gas reduction device has a modular structure that can include multiple reaction chambers successively.

Specifically, the disclosure is configured with a plurality of reaction modules 100 and one water treatment module 200 arranged together with the reaction modules. In addition, rather than being arranged within the reaction module 100, the water tank and the water treatment exhaust pipe are integrated into one body and disposed in the water treatment module 200 only. In other words, the reaction module 100 includes the reaction chamber 120 therein, but does not include the water tank and the water treatment exhaust pipe. The water tank and the water treatment exhaust pipe 220 are integrated as one body and disposed in the water treatment module 200.

The reaction chamber 120 that may be similar to the related reaction chamber is located in the reaction module 100 as a chamber for reaction with waste gas. In addition, a water treatment exhaust pipe 220 for purifying waste gas burned in the reaction chamber 120 is located in the water treatment module 200. Further, the reaction chamber in the reaction module and the water treatment exhaust pipe of the water treatment module are connected to each other through a connection pipe 140 so as to allow the waste gas or water to move. Multiple reaction modules 100 are disposed near one water treatment module 200 and disposed in various arrangements (described below). It is possible to arrange the reaction modules 100 around the water treatment module 200 in the center, and the number of the reaction modules 100 may vary as necessary, such as 4 to 10.

Referring to FIGS. 4A to 5, the connection pipe 140 is located below the reaction chamber 120 while communicating with the reaction chamber and connected to the water treatment exhaust pipe 220, and the connection pipe has shutoff valves 150 on both sides respectively. A shutoff valve 155 is further provided on an upper side of the connection pipe 140 so as to block the connection pipe 140 from the reaction chamber. That is, one unit reaction module is provided with three shutoff valves on the left and right sides and on the upper side. The above configuration ensures that the reaction chambers are individually blocked from communicating with the other in case of a failure of one of the reaction chambers, or the like. That is, as the shutoff valves 150 are operated, the shutoff valves 150 ensure that the reaction chamber 120 of a specific reaction module is blocked and isolated from communicating with the reaction chamber of a neighboring reaction module.

The structure of FIG. 4B shows a modification of the structure of the connection pipe 140 in FIG. 4A, and shows that it is possible to replace with the connecting pipe shown in FIG. 4B for a process during which a large amount of powder is generated. That is, a container type structure is applied to the existing configuration so as to collect and contain the powder for a while, in which case this part will be cleaned at regular maintenance.

In addition, as shown in FIGS. 6 and 7, a structure is also desirable, in which the shutoff valves 250 are provided on both sides of the connection pipe located below the water treatment exhaust pipe 220 to block communication between the water treatment exhaust pipe and the adjacent reaction chamber. FIGS. 6 and 7 are views of the water treatment module viewed from different angles.

A plurality of reaction modules are arranged adjacent to both left and right sides of the water treatment module, and the shape of the arrangement structure thereof may vary. For example, they may be arranged on sides in a transverse direction as shown in FIG. 2, or as shown in FIGS. 8 and 9, a plurality of reaction modules 100 may be arranged radially around the water treatment module 200 in the center. FIG. 9 is a plain view of FIG. 8 viewed from the upper side. Referring to FIG. 8, one or two reaction modules 100 may be omitted according to need (see FIGS. 10 and 11), in which case it is possible to provide high space utilization because any one configuration can be removed depending on situations of the place where the waste gas reduction device according to an embodiment is installed (e.g., depending on presence of pillars or the needs for the space utilization). FIG. 11 is a view of the waste gas reduction device of FIG. 10 viewed from the upper side.

FIG. 12 illustrates the water treatment module 200 located in the center of the pattern shown in FIGS. 8 to 11, and it is seen that the shutoff valves 250 are configured radially below the center and connected to the connection pipe, thus connecting the reaction modules radially.

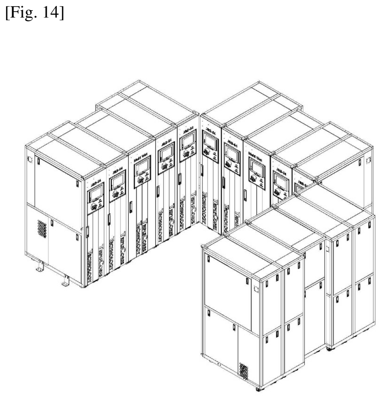

FIGS. 13 and 14 illustrate other forms of the arrangement structure of the waste gas reduction device with multiple reaction chambers according to an embodiment. Referring to the drawings, a plurality of reaction modules of the waste gas reduction device are arranged adjacent to the left and right sides of the water treatment module, forming a 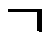 -shape or a 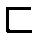 -shape as a whole. That is, in addition to the straight and circular shapes shown above, the shape of the waste gas reduction device according to an embodiment can vary (to T-shaped structure, 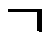 -shaped structure, 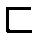 -shaped structure, and so on) and it is possible to install special gate valves on connection parts respectively to block external air and water, and also install water sprayers as necessary to clean the gas phase and lower the internal temperature.

In addition, the waste gas reduction device according to an embodiment provides advantages in that the arrangement of several scrubbers in a short distance makes it easy to check and manage the condition of the equipment, and also allows installation in an independent space of a certain region, thereby saving space. That is, space (floor space of the equipment0 can be saved by sharing and using several units in a bundle in the space for operating one existing individual unit. In addition, the back up between neighboring devices is necessary in preparation for an emergency situation, and the backup function can be established more advantageously as the distance between the devices is closer. Therefore, since 2 to 10 units are gathered, cost for the connection pipe can be saved, and additional equipment can be installed very simply as necessary. Since the device can be manufactured in various forms according to the situation of the installation site, it is possible to customize according to the space arrangement at the site.

**Table below shows the cost reduction of the waste gas reduction device according to an embodiment compared to the related equipment.**

| | Space | Operating Cost | Product Price |
|---|---|---|---|
| Related Scrubber Device | 100% | 100% | 100% |
| Gas Reduction Device of The Disclosure | 56% | 85% | 68% |

Referring to the table above, the use of space is reduced by about 56% thus indicating increased space utilization, and the operation cost is reduced by about 15% by the common use of water, and additionally, the final cost is further reduced by the reduced amount of waste water. In addition, the price of the product is reduced by about 30% or more by using the common wet tank and wet tower. In addition, according to the disclosure, it is easy to access even an old factory without a space for the scrubber because it is possible to install more equipment in a small space, and management is also convenient when installing in a new factory.

Although the present invention has been described in connection with some examples herein, the present invention should not be limited to those examples only, and various other changes and modifications made by those skilled in the art from the basic concept of the disclosure are also within the scope of the claims appended herein.

## Claims

1. A device for reducing waste gas, comprising:
a reaction module 100 including a reaction chamber 120 therein and excluding a water tank and a water treatment exhaust pipe;
a water treatment module 200 including a water tank and a water treatment exhaust pipe 220 therein; and
a connection pipe 140 connecting the reaction chamber in the reaction module to the water treatment exhaust pipe of the water treatment module,
wherein there are a plurality of reaction modules arranged, and the reaction chamber of each reaction module is connected to the water treatment exhaust pipe through the connection pipe.

2. The device of claim 1, wherein the connection pipe includes shutoff valves (150, 155) on both sides and an upper portion of the connection pipe located below the reaction chamber.

3. The device of claim 2, wherein shutoff valves 250 are provided on both sides of the connection pipe located below the water treatment exhaust pipe so as to block communication between the water treatment exhaust pipe and the neighboring reaction chamber.

4. The device of claim 1, wherein there are a plurality of reaction modules arranged adjacent to the left and right sides of the water treatment module.

5. The device of claim 4, wherein the reaction modules and the water treatment module are arranged adjacent to each other so as to form a 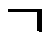 -shape or a 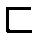 -shape arrangement as a whole.

6. The device of claim 1, wherein there are a plurality of reaction modules arranged adjacent to the left or right side of the water treatment module.

7. The device of claim 1, wherein there are a plurality of reduction modules arranged radially around the water treatment module in the center.

8. The device of claim 1, wherein the reaction chamber uses any one of a reaction type including a thermal type, a burn type, a plasma type, and a type utilizing catalyst.
